(19) Europäisches Patentamt
European Patent Office
Office européen des brevets

(11) **EP 2 223 771 A1**

(12) **EUROPEAN PATENT APPLICATION**
published in accordance with Art. 153(4) EPC

(43) Date of publication:
**01.09.2010 Bulletin 2010/35**

(51) Int Cl.:
**B23K 35/363** (2006.01)     **H05K 3/34** (2006.01)

(21) Application number: **08855551.1**

(22) Date of filing: **25.11.2008**

(86) International application number:
**PCT/JP2008/071356**

(87) International publication number:
**WO 2009/069600 (04.06.2009 Gazette 2009/23)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **27.11.2007 JP 2007305636**

(71) Applicant: **Harima Chemicals, Inc.**
**Hyogo 675-0019 (JP)**

(72) Inventors:
• **ISHIKAWA, Shunsuke**
**Kakogawa-shi**
**Hyogo 675-0019 (JP)**

• **SHINOZUKA, Akira**
**Kakogawa-shi**
**Hyogo 675-0019 (JP)**
• **AIHARA, Masami**
**Kakogawa-shi**
**Hyogo 675-0019 (JP)**

(74) Representative: **Ackroyd, Robert**
**W.P. Thompson & Co.**
**55 Drury Lane**
**London**
**WC2B 5SQ (GB)**

(54) **FLUX FOR SOLDERING AND SOLDERING PASTE COMPOSITION**

(57)     There is provided a soldering flux in which the volatilized amount in reflow is reduced to enable soldering with a smaller environmental load while suppressing the stickiness of the flux residue and ensuring a high reliability. A solder paste composition using the same is also provided. The soldering flux comprises a base resin, an activating agent, and a solvent, wherein the solvent comprises an oil component having an iodine value of 120 to 170. Preferably, the content of the oil component is 22 to 80 % by weight relative to the whole flux. Also, the oil component preferably contains at least one of drying oil and semidrying oil, and more preferably contains one or more kinds selected from tung oil, poppy-seed oil, walnut oil, safflower oil, sunflower oil, and soy bean oil. The solder paste composition comprises the soldering flux described above and a solder alloy powder.

EP 2 223 771 A1

**Description**

TECHNICAL FIELD

The present invention relates to a soldering flux and a solder paste composition that are used, for example, at the time of performing solder connection of a circuit component or the like to a circuit substrate.

BACKGROUND ART

Generally, a solder paste composition is constructed with a flux composed of a base resin such as rosins, a solvent, an activating agent and a thixotropic agent, a solder powder and the like. Here, as the solvent used in the flux, a volatile organic compound (hereafter referred to as VOC) such as represented by diethylene glycol monobutyl ether (butylcarbitol) or diethylene glycol mono-n-hexyl ether (hexylcarbitol) is generally used. The reason why such a solvent is used lies in that it is excellent in the solubility of the flux components, that a viscosity stability at the time of continuous printing can be easily ensured, and that it has an excellent property that the electric insulation resistance is not deteriorated because it will be volatilized when the solder is melted.

However, VOC can be a causing substance of photochemical oxidant, so that in recent years, a measure for limiting the use thereof (VOC countermeasure) is demanded in view of the consideration to the earth environment. Therefore, as a VOC countermeasure, for example, a water-soluble solder paste in which the solvent is replaced with water by using a water-soluble substance as a flux component (See Patent document 1), and a soldering flux in which water is used as a solvent, and a conventional hydrophobic base resin is dispersed (See Patent document 2) are proposed.

However, when a water-soluble solder paste of Patent document 1 is used, a water-washing step, a water-rinsing step, and the like will be needed, thereby raising a problem of increasing the number of steps, thereby increasing the product costs of electric components or the like, and also raising a problem such that it necessitates processing of an exhaust liquid generated in the washing and rinsing steps. On the other hand, in the soldering flux of Patent document 2, there is a fear in the stability at the time of use or at the time of storage, since non-water-soluble resin is emulsified or dispersed. Also, there is a problem that it is extremely difficult to maintain the stability of the dispersed particles when the flux is kneaded with a solder powder to make a solder paste.

For this reason, as a VOC countermeasure in a soldering flux, a measure using a solvent which is not water and which is an organic solvent having a high boiling point that is volatilized little in reflowing is viewed as prospective. However, a flux containing an ordinary amount of an organic solvent having a high boiling point provides a poor drying property, raising a problem that the stickiness of the flux residue after soldering will be high, or a problem that migration occurs to decrease the reliability. Therefore, when an organic solvent having a high boiling point is used, the content of the solvent in the flux must be designed to be low to some degree. However, when the content of the solvent is reduced, the viscosity of a solder paste will be high, so that the workability decreases considerably.

Accordingly, it is the current state that a VOC countermeasure suppressing the stickiness of the flux residue and enabling soldering with a high reliability while using an ordinary amount of solvent so that a good workability may be ensured has not been established.

Patent document 1: Japanese unexamined Patent Application No. H10-85985
Patent document 2: Japanese unexamined Patent Application No. 2007-144446

DISCLOSURE OF THE INVENTION

The present invention provides a soldering flux in which the volatilized amount in reflowing is reduced to enable soldering with a smaller load to the environment while suppressing the stickiness of the flux residue to ensure a high reliability. Also, there is provided a solder paste composition using the flux.

The present inventors have made eager researches in order to solve the aforementioned problems and, as a result, have found out a new fact that, when an oil component having an iodine value of 120 to 170 is used as a solvent in the flux, the oil component reacts with oxygen in reflowing and is hardened by oxidation polymerization, so that the volatilized amount in reflowing can be greatly reduced, and also the residual of liquid substances in the flux residue can be suppressed, thereby solving problems such as increase in the stickiness of the residue and decrease in the reliability, thereby completing the present invention.

Namely, the soldering flux of the present invention comprises a base resin, an activating agent, and a solvent, wherein the solvent contains an oil component having an iodine value of 120 to 170. In this constitution, the content of the aforesaid oil component is preferably 22 to 80 % by weight relative to the total amount of the flux. Also, the oil component preferably contains at least one of drying oil and semidrying oil, and more preferably contains one or more kinds selected from the group consisting of tung oil, poppy-seed oil, walnut oil, safflower oil, sunflower oil, and soybean oil. The solder paste composition of the present invention comprises the aforesaid soldering flux of the present invention and a solder alloy powder.

According to the present invention, by using an oil component having an iodine value of 120 to 170 as a solvent contained in the flux, hardening by oxidation polymerization is allowed to occur in reflowing. As a result, an effect can be obtained such that the volatilized amount in reflowing is greatly reduced to enable soldering with a smaller load to the environment while suppressing the stickiness of the flux residue to ensure a high reliability.

BEST MODES FOR CARRYING OUT THE INVENTION

Hereafter, one embodiment of the present invention will be described in detail.
The soldering flux (which may hereafter be simply referred to as "flux") of the present invention contains a specific oil component as a solvent. Here, the oil component means one kind of oil or a mixture of two or more kinds of oil. The oil is typically in a liquid form at an ordinary temperature (room temperature). For this reason, by using an oil component as a solvent, the oil component functions as a solvent in a liquid form to ensure a good workability when the solder paste composition is used for soldering. Also, at the time of reflowing, the oil component reacts with oxygen in air to cause oxidation polymerization to be hardened. As a result, the volatilized amount in reflowing can be greatly reduced, and also the residual of liquid substances in the flux residue can be suppressed, thereby avoiding problems such as increase in the stickiness of the residue and decrease in the reliability.

It is important that the iodine value of the aforesaid oil component is 120 to 170. Preferably, the iodine value is 125 to 165. when the iodine value of the oil component is lower than 120, the hardening of the film by oxidation polymerization in reflowing is insufficient, thereby inviting stickiness of the residue, and decreasing in the reliability. On the other hand, when the iodine value exceeds 170, an excessive oxidation polymerization reaction proceeds at the time of storing or working the flux or the solder paste composition. As a result, the viscosity rises to deteriorate the stability, thereby reducing the workability.
When the oil component is composed of two or more kinds of oil, it is sufficient that the iodine value of the oil component as a whole is 120 to 170.

The oil component preferably contains at least one of drying oil and semidrying oil. In particular, the oil component more preferably contains at least one of a drying oil having an iodine value of 120 to 170 and a semidrying oil having an iodine value of 120 to 170. The drying oil having an iodine value of 120 to 170 may be, for example, tung oil, poppy-seed oil, walnut oil, and safflower oil. The semidrying oil having an iodine value of 120 to 170 may be, for example, sunflower oil or soy bean oil.
When the oil component is composed of two or more kinds of oil, the oil component is preferably composed only of at least one of a drying oil and a semidrying oil, and more preferably is composed only of at least one of a drying oil having an iodine value of 120 to 170 and a semidrying oil having an iodine value of 120 to 170. However, as long as the mixing ratio of each oil is adjusted so that the iodine value of the mixed oil component as a whole will be 120 to 170, the oil component may contain an oil having an iodine value of less than 120 or an oil having an iodine value exceeding 170. The oil having an iodine value of less than 120 may be, for example, jojoba oil, castor oil, coconut oil, sesame oil, or the like. The oil having an iodine value exceeding 170 may be, for example, linseed oil, beefsteak plant oil, or the like.

The content of the oil component (when it is a mixture of two or more kinds of oil, the combined content thereof) is preferably 22 to 80 % by weight, more preferably 35 to 65 % by weight, relative to the total amount of the flux. When the content of the oil component is less than 22 % by weight, the amount of liquid components in the flux will be smaller, whereby the flux will have a higher viscosity, and the workability may decrease considerably. On the other hand, when the content of the oil component exceeds 80 % by weight, the amount of components that clean the solder metal will be smaller, whereby sufficient solderability may not be obtained, and also the workability may decrease due to the viscosity of the flux becoming low.

The flux of the present invention may contain, for example, a high-boiling-point solvent that is conventionally used generally in a flux, such as a polyhydric alcohol type solvent, an ether type solvent, or an ester type solvent, within a range that does not deteriorate the effects of the present invention, as a solvent other than the above-mentioned oil component. In that case, in consideration of the purpose of the present invention, it is preferable to use a solvent which is a polar solvent that can dissolve flux components such as a base resin and an activating agent and which has a boiling point of 400°C or higher. Such a high-boiling-point solvent may be, for example, polyhydric alcohol such as polyethylene glycol, polypropylene glycol, or polyglycerin, an ether compound or an ester compound thereof, trimellitic acid ester, phthalic acid ester, sorbitol ether, or the like. Typically, the content of these high-boiling-point solvents is preferably 30 % by weight or less relative to the total amount of the flux.

In addition to the solvent, the flux of the present invention contains a base resin and an activating agent, and may further contain a thixotropic agent and other additives in accordance with the needs.
The base resin may be, for example, an ordinary rosin or a derivative thereof that is conventionally used generally in a flux, or a synthetic resin that is conventionally used generally in a flux. The rosin may be, for example, gum rosin, tall oil rosin, wood rosin, or the like. The rosin derivative may be, for example, polymerized rosin, acrylated rosin, hydrogenated rosin, formylated rosin, rosin ester, rosin-modified maleic acid resin, rosin-modified phenolic resin, rosin-modified alkyd resin, or the like. The synthetic resin may be, for example, styrene-maleic acid resin, epoxy resin, urethane resin, or the like. The content of the base resin is not particularly limited; however, the content is preferably 5 to 75 % by weight relative to the total amount of the flux.

The activating agent is not particularly limited; however, in consideration of the purpose of the present invention, which is a VOC countermeasure, the activating agent preferably has a low volatility. The activating agent may be, for example, a hydrohalide such as ethylamine, propylamine, diethylamine, triethylamine, ethylenediamine, or aniline, an organic carboxylic acid such as lactic acid, citric acid, stearic acid, adipic acid, tridecanedioic acid, dodecanedioic acid, or the like. The content of the activating agent is not particularly limited; however, the content is preferably 0.1 to 20 % by weight relative to the total amount of the flux. When the amount of the activating agent is less than 0.1 % by weight, the activating power will be insufficient, and the solderability may decrease. On the other hand, when the amount of the activating agent exceeds 20 % by weight, the coating film property of the flux will decrease, and hydrophilicity is enhanced, whereby the corrosion property and the insulation property may decrease.

The thixotropic agent is not particularly limited; however, the thixotropic agent may be, for example, hardened castor oil, beeswax, carnauba wax, stearic acid amide, hydroxystearic acid ethylenebisamide, or the like. The content of the thixotropic agent is not particularly limited; however, the content is preferably 0.5 to 25 % by weight relative to the total amount of the flux.

The other additives may be, for example, an antioxidant, a rust-preventive agent, a chelating agent, or the like. The content of these other additives may be suitably set within a range that does not deteriorate the effect of the present invention.

The solder paste composition of the present invention contains the soldering flux of the present invention described above and a solder alloy powder.

The solder alloy powder is not particularly limited, so that it is possible to use a tin-lead alloy that is generally used, or further a tin-lead alloy to which silver, bismuth, indium, or the like has been added, or the like. Also, a lead-free alloy such as tin-silver type, tin-copper type, or tin-silver-copper type may be used. The particle size of the solder alloy powder is preferably 5 to 50 $\mu$m.

The ratio of the flux and the solder alloy powder in the solder paste composition of the present invention may be suitably set in accordance with the usage or function of the desired solder paste, and therefore is not particularly limited; however, the ratio is preferably flux : solder alloy powder (weight ratio) = about 5 : 95 to 20 : 80.

In performing solder connection of electronic apparatus component or the like, the solder paste composition of the present invention is applied onto a substrate by a dispenser, screen printing, or the like. Then, after the application, preheating is carried out, for example, at about 150 to 200°C, and reflowing is carried out at the maximum temperature of about 170 to 250°C.

EXAMPLES

Hereafter, the present invention will be described in more detail by citing Examples and Comparative Examples; however, the present invention is not limited to the following Examples.

(Examples 1 to 6 and Comparative Examples 1 to 3)

Each component of the fluxes shown in Table 1 was put into a container with a blending ratio shown in Table 1 and, and is heated and dissolved, followed by cooling to obtain fluxes, respectively.

Next, in the container, each of the obtained fluxes and a solder alloy powder (melting point: 219°C, particle size: 30 to 20 $\mu$m) of Sn-Ag-Cu alloy (Sn : Ag : Cu (weight ratio) = 96.5 : 3.0 : 0.5) were mixed at a ratio of flux : solder alloy powder (weight ratio) = 11 : 89 and stirred to obtain solder paste compositions, respectively.

Each of the obtained solder paste compositions was evaluated by the following methods. The results are shown in Table 1.

<Volatility of flux>

A solder paste composition was printed onto a copper plate (80 mm x 40 mm x 0.3 mm) with use of a metal mask having a thickness of 150 $\mu$m and having ten openings of 10 mm x 10 mm. At this time, the weight (a) of the copper plate immediately after the printing was measured, so as to determine the weight (A) of the solder paste composition that had been printed from the weight difference of the copper plate before and after the printing. Within 30 minutes after the printing, preheating was carried out in an ambient atmosphere at 175 $\pm$ 5°C for 80 $\pm$ 5 seconds, and reflowing was carried out at the maximum temperature of 235 $\pm$ 5°C. The weight (b) of the copper plate after the reflowing was measured, so as to calculate the volatility ratio (%) of the flux based on the following formula from the weight difference (a - b) before and after the reflowing and the flux content (namely, 11 % by weight).

$$\text{Volatility ratio (\%)} = [(a - b) / (A \times 0.11)] \times 100$$

<Insulation property>

On a comb-shaped substrate (II type) defined in JIS-Z-3197, a solder paste composition was printed with use of a metal mask having a thickness of 100 $\mu$m and having the same pattern. Within 10 minutes after the printing, preheating was carried out in an ambient atmosphere at 175 $\pm$ 5°C for 80 $\pm$ 5 seconds, and reflowing was carried out at the maximum temperature of 235 $\pm$ 5°C. The substrate having been subjected to the reflowing was left to stand in a thermostat humidistat tank having a temperature of 85°C and a humidity of 85%. By measuring the resistance value ($\Omega$) after 1000 hours, the insulation property was evaluated as an index of electric reliability.

Here, for example, when the resistance value of Example 1 was 6 x 10$^9$ $\Omega$, this is denoted as "6E9" in Table 1. The other resistance values are also denoted in the same manner.

<Corrosion property>

With use of the solder paste composition, a copper plate corrosion test piece defined in JIS-Z-3284 was prepared and, after the test piece was left to stand in a thermostat humidistat tank having a temperature of 40°C and a humidity of 85% for 96 hours, visual observation was carried out to confirm the presence or absence of the corrosion generation.

<Stickiness of residue>

With use of the solder paste composition, a drying degree test piece defined in JIS-Z-3284 was prepared. After talc powder was attached to the test piece cooled to ordinary temperature, the surface was lightly brushed with a soft brush. At this time, visual observation was carried out to confirm the presence or absence of the attachment of powder talc.

<Viscosity stability>

With use of the solder paste composition, continuous printing of 12 hours was carried out to measure the viscosity before and after the continuous printing. The difference thereof was regarded as a viscosity rising value (Pa. S).
[Table 1]

| | | Examples | | | | | | Comparative Examples | | |
|---|---|---|---|---|---|---|---|---|---|---|
| | | 1 | 2 | 3 | 4 | 5 | 6 | 1 | 2 | 3 |
| Flux composition / wt % | Polymerized rosin | 45.0 | 45.0 | 45.0 | 39.0 | 35.0 | 36.0 | 50.0 | 45.0 | 45.0 |
| | Hardened castor oil | 5.0 | 5.0 | 5.0 | 5.0 | 5.0 | 5.0 | 5.0 | 5.0 | 5.0 |
| | Walnut oil (Iodine : 145) | 44.5 | 25.0 | 25.0 | — | — | 15.0 | — | 11.5 | — |
| | Soybean oil (Iodine : 128) | — | — | 15.0 | 40.5 | 20.0 | 22.0 | — | — | 27.0 |
| | Linseed oil (Iodine : 185) | — | 19.5 | — | — | 20.0 | — | — | 33.0 | 7.5 |
| | Coconut oil (Iodine : 10) | — | — | 4.5 | — | 4.5 | 6.5 | — | — | 10.0 |
| | Toridecanedioic acid | 5.0 | 5.0 | 5.0 | 5.0 | 5.0 | 5.0 | 5.0 | 5.0 | 5.0 |
| | Ethylamine hydrochloride | 0.5 | 0.5 | 0.5 | 0.5 | 0.5 | 0.5 | 0.5 | 0.5 | 0.5 |
| | Polyethylene glycol | — | — | — | 10.0 | 10.0 | 10.0 | — | — | — |
| | Hexylcarbitol | — | — | — | — | — | — | 39.5 | — | — |
| | Iodine value of whole oil components | 145 | 163 | 126 | 128 | 142 | 125 | 0 | 175 | 111 |
| Examination results | Volatility of flux : volatility ratio (%) | 3.6 | 3.3 | 3.8 | 4.5 | 4.3 | 4.6 | 42.3 | 3.1 | 3.4 |
| | Insulation property : Resistance value (Ω) | 6E9 | 5E9 | 6E9 | 3E9 | 4E9 | 3E9 | 6E9 | 3E9 | 6E7 |
| | Corrosion property : Corrosion generation | Non | Non | Non | Non | Non | Non | Non | Non | Yes |
| | Stickiness of residue : Attachment of talc powder | Non | Non | Non | Non | Non | Non | Non | Non | Yes |
| | Viscosity stability : Viscosity rising value (Pa.S) | 10 | 25 | 5 | 5 | 20 | 5 | 15 | 110 | 10 |

From Table 1, it is understood that, when a solder paste composition of Examples 1 to 6 using an oil component having an iodine value of 120 to 170 is used as a solvent in the flux, the generation of volatile substances in reflowing (at the time of heating and melting the solder) is suppressed, whereby the load imposed upon the environment can be reduced. Also, it is understood that, when a solder paste composition of Examples 1 to 6 is used, the viscosity does not rise in continuous printing, and also, hardening occurs due to oxidation polymerization reaction of the oil component, so that there is no generation of inconveniences such as decrease in the insulation property, corrosion, and stickiness generation of the residue, whereby a high reliability and a good workability can be maintained.

On the other hand, in a conventional solder paste composition of Comparative Example 1 using hexylcarbitol which is a volatile organic compound as a solvent in the flux, though a high reliability is provided, there arises a problem in that the volatility of the flux is high and the load imposed upon the environment is large. Also, in a solder paste composition of Comparative Example 2 in which the iodine value of the oil component used as a solvent in the flux exceeds 170, though no problem is raised in view of suppressing the generation of volatile substances and ensuring the reliability, it is clear that the viscosity rise after continuous printing is large, and the workability is deteriorated. Also, in a solder paste composition of Comparative Example 3 in which the iodine value of the oil component used as a solvent in the flux is less than 120, though the generation of volatile substances can be suppressed, it is clear that there arises a problem of generation of deterioration in the properties such as insulation property, corrosion property, and stickiness of the residue.

As shown above, the soldering flux and the solder paste composition of the present invention have been described in detail; however, the scope of the present invention is not restricted by these descriptions, so that suitable changes or modifications can be made within a range that does not deteriorate the gist of the present invention.

**Claims**

1. A soldering flux comprising a base resin, an activating agent, and a solvent, wherein the solvent comprises an oil component having an iodine value of 120 to 170.

2. The soldering flux according to claim 1,
   wherein the content of the oil component is 22 to 80 % by weight relative to the total amount of the flux.

3. The soldering flux according to claim 1 or 2, wherein the oil component is at least one of drying oil and semidrying oil.

4. The soldering flux according to claim 3,
   wherein the oil component is one or more kinds selected from the group consisting of tung oil, poppy-seed oil, walnut oil, safflower oil, sunflower oil, and soy bean oil.

5. A solder paste composition comprising a soldering flux according to any one of claims 1 to 4, and a solder alloy powder.

<div align="center"><b>INTERNATIONAL SEARCH REPORT</b></div>

| | International application No. |
|---|---|
| | PCT/JP2008/071356 |

**A. CLASSIFICATION OF SUBJECT MATTER**
*B23K35/363(2006.01)i, H05K3/34(2006.01)i*

According to International Patent Classification (IPC) or to both national classification and IPC

**B. FIELDS SEARCHED**

Minimum documentation searched (classification system followed by classification symbols)
B23K35/363, H05K3/34

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 10-034383 A  (Sophia Systems Co., Ltd.), 10 February, 1998 (10.02.98), Claims & US 5851311 A          & US 5989362 A | 1-5 |
| A | JP 2002-514973 A  (Fry's Metals Inc.), 21 May, 2002 (21.05.02), Claims & US 5904782 A          & WO 1996/037336 A1 | 1-5 |
| A | JP 9-192883 A  (Asahi Chemical Research Laboratory Co., Ltd.), 29 July, 1997 (29.07.97), Claims (Family: none) | 1-5 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 February, 2009 (20.02.09) | 03 March, 2009 (03.03.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/071356

C (Continuation).　DOCUMENTS CONSIDERED TO BE RELEVANT

| Category* | Citation of document, with indication, where appropriate, of the relevant passages | Relevant to claim No. |
|---|---|---|
| A | JP 8-132282 A (San-Ei Kagaku Co., Ltd.), 28 May, 1996 (28.05.96), Claims (Family: none) | 1-5 |
| A | JP 2001-114747 A (Fujifilm Olin Co., Ltd.), 24 April, 2001 (24.04.01), Claims (Family: none) | 1-5 |
| A | JP 63-289991 A (Uchihashi Estec Co., Ltd.), 28 November, 1988 (28.11.88), Claims (Family: none) | 1-5 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H1085985 B
- JP 2007144446 A